# EUROPÄISCHE PATENTSCHRIFT

(11) **EP 1 741 133 B1**
(45) Veröffentlichungstag und Bekanntmachung des Hinweises auf die Patenterteilung: **20.07.2011**
(21) Anmeldenummer: 05743044.9
(22) Anmeldetag: 22.04.2005
(51) Int. Cl.: H01L 21/8249

(54) **VERFAHREN ZUR HERSTELLUNG EINES PLANAREN SPACERS, EINES ZUGEHÖRIGEN BIPOLARTRANSISTORS UND EINER ZUGEHÖRIGEN BICMOS-SCHALTUNGSANORDNUNG**
METHOD FOR PRODUCING A PLANAR SPACER, AN ASSOCIATED BIPOLAR TRANSISTOR AND AN ASSOCIATED BICMOS CIRCUIT ARRANGEMENT
PROCEDE POUR PRODUIRE UN ESPACEUR PLAN, UN TRANSISTOR BIPOLAIRE ASSOCIE ET UN ENSEMBLE CIRCUIT BICMOS ASSOCIE

(30) Priorität: 30.04.2004 DE 102004021241
(43) Veröffentlichungstag der Anmeldung: 10.01.2007
(73) Patentinhaber: Infineon Technologies AG, 85579 Neubiberg (DE)
(72) Erfinder: DAHL, Claus, 01109 Dresden (DE); TILKE, Armin, Beacon, New York 12508 (US)
(74) Vertreter: Kindermann, Peter
(86) Internationale Anmeldenummer: PCT/EP2005/051805
(87) Internationale Veröffentlichungsnummer: WO 2005/109494

(56) Entgegenhaltungen:
- WO-A-2004/015755
- US-A- 5 057 455
- US-A1- 2004 014 271
- US-A1- 2004 072 399
- US-B1- 6 586 307

## Beschreibung

Die vorliegende Erfindung bezieht sich auf ein Verfahren zur Herstellung eines planaren Spacers, eines zugehörigen Bipolartransistors und einer zugehörigen BiCMOS-Schaltungsanordnung und insbesondere auf ein Verfahren zur Herstellung von selbstjustierten Single-Poly-Bipolartransistoren mit verbesserten elektrischen Eigenschaften in einer BiCMOS-Schaltung.

In Bipolartransistoren muss das Gebiet der intrinsischen Basis möglichst niederohmig kontaktiert bzw. angeschlossen werden, um höchste Grenzfrequenzen zu erreichen und das HF-Rauschen zu verringern. Dieses erreicht man besonders vorteilhaft mit einem möglichst kurzen und vorzugsweise selbstjustierten und daher niederohmigen Basisanschluss.

Bei sogenannten "Single-Poly-Bipolartechnologien" wird dieses Basisanschlussgebiet im Regelfall lithographisch, also nicht selbst justiert, definiert. Beispielsweise verwendet man den lithographisch definierten Emitterstöpsel als Implantationshartmaske für den Basiskontakt. Da die Dotierung der intrinsischen Basis die Stromverstärkung des Bipolartransistors festlegt, kann sie nicht beliebig hoch gewählt werden. Wird der Basisanschluss bzw. das die intrinsische Basis unmittelbar berührende Basisanschlussgebiet durch keine eigene, hochdotierte Polysiliziumschicht gebildet, die es erlaubt die intrinsische Basis selbstjustiert zu kontaktieren, wird im Regelfall der Basisanschluss durch Ionenimplantation mittels einer z.B. Fotolackmaske hochdotiert. Dabei ist der minimale Abstand dieses hochdotierten Anteils des Basisanschlusses zum aktiven Transistorbereich, d.h. zur intrinsischen Basis, durch die Lithographietoleranzen bestimmt. Aus diesem Grund ist in derartigen "Single-Poly-Bipolartransistoren" der Basisanschluss relativ hochohmig, da das hochdotierte Anschlussgebiet durch dieses relativ lange nur mit der niedrigen Dotierstoffkonzentration der intrinsischen Basis dotierte Gebiet, mit der intrinsischen Basis verbunden ist.

Herkömmliche Bipolartransistoren verwenden daher oftmals zwei Polysiliziumlagen zur Realisierung einer Kontaktierung, wobei eine für die Emitterkontaktierung und eine für die Basiskontaktierung vorgesehen ist. Dabei wird ein Emitterfenster, welches einen eigentlichen Kontaktbereich zwischen dem Emitter und der intrinsischen Basis festlegt, durch das hochdotierte Basisanschluss-Polysilizium geätzt. Damit liegt der Basisanschluss automatisch selbstjustiert neben dem Emitterfenster, in dem die intrinsische Basis definiert wird. Den niederohmigen Basisanschluss erhält man bei dieser Variante durch Ausdiffusion aus dem Basisanschluss-Polysilizium zur intrinsischen Basis.

Bei einem herkömmlichen Single-Poly-Bipolartransistor, bei dem nur für den Emitterkontakt eine eigene Polysiliziumabscheidung bzw. Polysiliziumschicht verwendet wird, wird das Basisanschlussgebiet üblicherweise lithographisch definiert und mittels Implantationen hoch dotiert. Da dieser Prozess demzufolge nicht selbstjustiert ist, beinhaltet er daher alle Lithographieschwankungen und -toleranzen.

Aus der Druckschrift WO 2004/015755 A ist ein Verfahren zur Herstellung eines Bipolartransistors bekannt, wobei Spacer unter Verwendung einer Opfermaske und einer zusätzlichen Ätzmaske hergestellt werden.

Aus der Druckschrift US 2004/014271 A1, auf der der Oberbegriff des Patentanspruchs 1 basiert, ist ein weiteres Verfahren zur Herstellung von Spacern bekannt, wobei nach dem Ausbilden einer Opfermaske, einer ersten Spacerschicht und einer zweiten Spacerschicht zunächst eine anisotrope Ätzung der zweiten Spacerschicht unter Verwendung der ersten Spacerschicht als Endpunkterkennung erfolgt. Anschließend erfolgt eine zweite Ätzung der ersten Spacerschicht, wobei wiederum eine darunterliegende Trägerschicht als Endpunkterkennung dient.

Aus der Druckschrift US-B1-6 586 307 ist ein Verfahren zur Steuerung einer Emitterfenster-Öffnung in einem Heterojunction Bipolartransistor (HBT) offenbart, wobei unter Verwendung eines Opfermaterials eine Emitteröffnung festgelegt werden kann, an deren Seitenwänden herkömmliche Spacer ausgebildet werden.

Die Druckschrift US-A1-2004/0072399 bezieht sich schließlich auf ein Verfahren zur Herstellung eines BICMOS-Transistors, wobei jedoch wiederum nur herkömmliche, d.h. vertikale, Spacerstrukturen zum Einsatz kommen.

Der Erfindung liegt daher die Aufgabe zu Grunde, ein Verfahren zur Herstellung eines planaren Spacers, eines zugehörigen Bipolartransistors und einer zugehörigen BICMOS-Schaltungsanordnung zu schaffen, wodurch Halbleiterbauelemente mit verbesserten elektrischen Eigenschaften kostengünstig hergestellt werden können.

Erfindungsgemäß wird diese Aufgabe hinsichtlich des planaren Spacers durch die Maßnahmen des Patentanspruchs 1, hinsichtlich des zugehörigen Bipolartransistors durch die Maßnahmen des Patentanspruchs 5 und hinsichtlich der zugehörigen BICMOS-Schaltungsanordnung durch die Maßnahmen des Patentanspruchs 14 gelöst.

Insbesondere durch das Durchführen einer zweiten anisotropen Ätzung derart, dass die vom Hilfs-Spacer bedeckten Bereiche des planaren Spacers im Wesentlichen eine gleiche Schichtdicke aufweisen wie die nicht bedeckten Bereiche des planaren Spacers, erhält man Bauelemente und insbesondere Bipolartransistoren mit verbesserten elektrischen Eigenschaften.

Vorzugsweise weist der Hilfs-Spacer und die Opfermaske ein gleiches Material auf, wodurch bei einem Entfernen der Hilfs-Spacer gleichzeitig auch die Opfermaske entfernt werden kann und sich demzufolge sehr einfach die eingangs beschriebenen Emitterfenster für Bipolartransistoren realisieren lassen.

Hinsichtlich des Verfahrens zur Herstellung eines Bipolartransistors mit den vorstehend beschriebenen planaren Spacern müssen demzufolge lediglich eine Basis-Halbleiterschicht als Basisschicht auf einem als Kollektorschicht wirkenden Halbleitersubstrat zur Realisierung des Trägersubstrats ausgebildet werden, wobei nach dem Ausbilden der Opfermaske eine Basisanschluss-Implantation zum Ausbilden von niederohmigen Basisanschlussgebieten und unter Maskierung der intrinsischen Basis in der Basisschicht durchgeführt wird, und nach einem Entfernen der Opfermaske eine als Emitterschicht dienende Emitter-Halbleiterschicht an der Oberfläche des Trägersubstrats und der planaren Spacer ausgebildet und strukturiert wird. Auf diese Weise kann mit einem selbstjustierten Verfahren ein optimaler Basisanschluss für z.B. eine mäßig p-dotierte intrinsische Basis realisiert werden (die innere Basis wird normalerweise ca. 1E18 bis 1E19 dotiert, die extrinsische Basis etwa 1E20 und höher). Man dotiert die innere Basis vorzugsweise so, dass zum einem die Stromverstärkung ausreichend hoch ist und die Diodenleckströme ausreichend niedrig sind, was durch eine geringe Basisdotierung gewährleistet wird. Andererseits sollte auch die innere Basis ausreichend niederohmig sein, damit insbesondere das HF-Rauschen niedrig wird.

Zudem gelten alle Ausführungen hier nicht nur für einen npn-Transistor, also mit einer p-dotierten Basis, sondern prinzipiell auch für einen pnp Transistor. Dort wäre die Basis dann n-dotiert.

Ferner kann die Basis dabei entweder durch Implantation oder Epitaxie ausgebildet werden.

Zumindest ein Teil der Opfermaske definiert demzufolge einen Emitterfenster-Bereich zum Festlegen eines Kontaktbereichs der Emitterschicht mit der intrinsischen Basis, wobei zum Festelegen eines vorbestimmten Abstands zwischen dem niederohmigen Basisanschlussgebiet und der intrinsischen Basis im Emitterfenster-Bereich Außenspacer an den Seitenwänden der Opfermaske und/oder Innenspacer an den Seitenwänden der planaren Spacer ausgebildet werden können. Auf diese Weise kann sichergestellt werden, dass die Basiskontakt-Implantation nur in Bereiche der Basisschicht mit geringer Qualität gelangt, z.B. polykristallinem Aufbau, während sich das effektive Emitterfenster immer auf bzw. oberhalb von monokristallinem Material der Basisschicht bzw. der mäßig dotierten Basis-Halbleiterschicht befindet.

Vorzugsweise wird die Basis-Halbleiterschicht daher zumindest im Emitterfenster-Bereich als monokristalline Verbund-Halbleiterschicht und insbesondere eine SiGe- oder SiGe:C-Halbleiterschicht epitaktisch aufgewachsen.

Hinsichtlich des Verfahrens zur Herstellung einer BiCMOS-Schaltungsanordnung werden in einem Halbleitersubstrat zunächst zumindest eine teilweise fertiggestellte Feldeffekttransistorstruktur in einem Feldeffekttransistor-Bereich ausgebildet und mit einer dünnen Passivierungsschicht passiviert, wobei nach dem Entfernen bzw. Öffnen der Passivierungsschicht in zumindest einem Bipolartransistor-Bereich des Halbleitersubstrats anschließend der vorstehend beschriebene Prozess zur Herstellung eines Bipolartransistors mit planaren Spacern durchgeführt wird. Insbesondere bei einer derartigen BiCMOS-Schaltungsanordnung ergeben sich besondere Vorteile aus den planaren Spacern dahingehend, dass die üblicherweise im Feldeffekttransistor-Bereich vorherrschenden starken Topographieunterschiede keinerlei Probleme bei der Herstellung des Bipolartransistors im Bipolartransistor-Bereich des Halbleitersubstrats verursachen. Folglich können erstmalig BiCMOS-Schaltungen mit verbesserten elektrischen Eigenschaften und verringerten Herstellungskosten realisiert werden.

Vorzugsweise kann nach dem Entfernen der Passivierungsschicht eine Subkollektor-Implantation zum Ausbilden eines vergrabenen Subkollektors im Halbleitersubstrat innerhalb des Bipolartransistor-Bereichs durchgeführt werden, wodurch sich ohne Zusatzkosten die elektrischen Eigenschaften weiter verbessern lassen. Insbesondere bei BiCMOS-Schaltungen mit Hochfrequenz- und/oder Hochvolt-Bipolartransistoren können somit unter Verwendung bereits vorhandener Lithographieebenen derartige vergrabene Subkollektoren einfach und kostengünstig hergestellt werden.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
Figuren 1A bis 1F vereinfachte Schnittansichten zur Veranschaulichung eines Verfahrens zur Herstellung eines planaren Spacers;
Figuren 2A bis 2F vereinfachte Schnittansichten zur Veranschaulichung eines Verfahrens zur Herstellung eines Bipolartransistors mit planaren Spacern; und
Figuren 3A bis 3J vereinfachte Schnittansichten zur Veranschaulichung eines Verfahrens zur Herstellung einer BiCMOS-Schaltungsanordnung mit erfindungsgemäßen planaren Spacern.

Die nachfolgende Figurenbeschreibung erläutert das erfindungsgemäße Konzept zur Herstellung eines planaren Spacers, wie er insbesondere in einem Bipolartransistor und einer zugehörigen BiCMOS-Schaltungsanordnung verwendet werden kann.

Insbesondere durch die Verwendung einer Opfermaske als Implantationshartmaske und als Fundament können planare Spacer zur selbstjustierten Ausbildung von Anschlussgebieten mit minimal möglichem Abstand zu einem später freiliegenden Bereich wie beispielsweise einer intrinsischen Basis eines Single-Poly-Bipolartransistors ausgebildet werden.

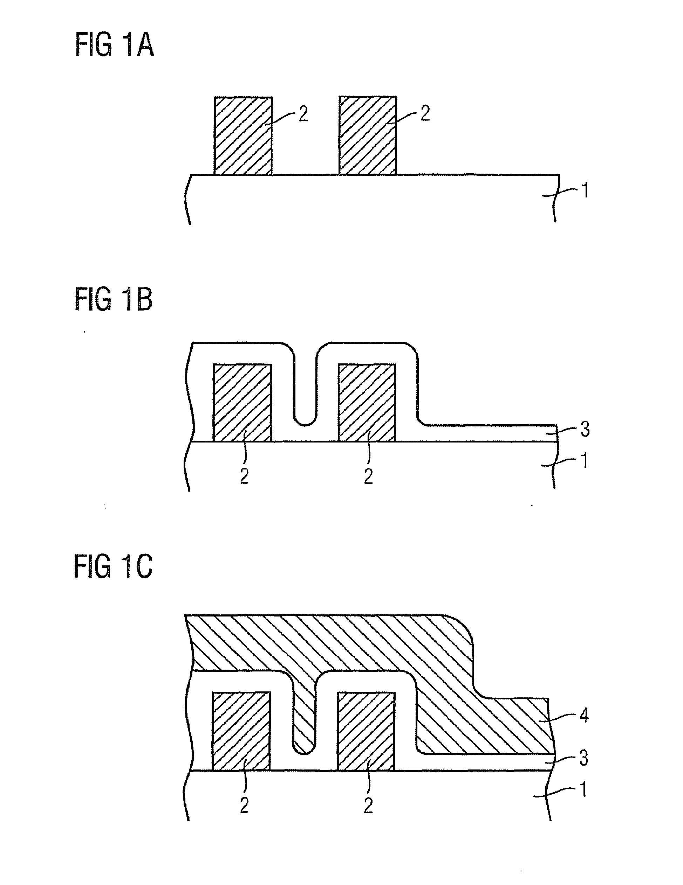

Zunächst wird anhand der Figuren 1A bis 1F ein erfindungsgemäßes Verfahren zur Herstellung eines planaren Spacers und insbesondere eines planaren Außenspacers beschrieben. Als planarer Außenspacer wird nachfolgend ein flacher im Wesentlichen ebener Spacer verstanden, der an den Außenwänden eines Maskenstöpsels ausgebildet ist.

Gemäß Figur 1A wird zunächst eine Opfermaske 2 auf einem Trägersubstrat 1 ausgebildet, wobei beispielsweise eine Si₃N₄-Schicht ganzflächig abgeschieden und anschließend mittels herkömmlicher Verfahren fotolithographisch strukturiert wird, d.h. unter Verwendung eines nicht dargestellten Fotoresists geätzt wird. Auf diese Weise erhält man die in Figur 1A dargestellte Opfermaske 2 mit beispielsweise zwei Nitridstöpseln, die einen geringen Abstand zueinander aufweisen, bzw. beispielsweise auf der rechten Seite einen weiten Abstand haben können.

Gemäß Figur 1B wird nach dem Ausbilden dieser Opfermaske 2 zunächst eine erste Spacerschicht 3 an der Oberfläche des Trägersubstrats 1 und der Opfermaske 2 ausgebildet. Beispielsweise wird hierbei ein konformales Abscheiden einer Si-O₂-Schicht als erste Spacerschicht 3 durchgeführt. Die Dicke dieser ersten Spacerschicht 3 sollte hierbei derart gering sein, dass auch im Bereich des geringen Abstands der Opfermaske die Zwischenräume nicht vollständig aufgefüllt werden.

Gemäß Figur 1C wird anschließend an der Oberfläche der ersten Spacerschicht 3 eine zweite Spacerschicht 4 ausgebildet. Die zweite Spacerschicht 4 wird beispielsweise wiederum abgeschieden und weist vorzugsweise eine Si₃N₄-Schicht auf. Die Dicke der zweiten Spacerschicht 4 ist vorzugsweise größer als die Dicke der ersten Spacerschicht 3, wobei der Bereich mit dem engen Abstand zwischen der Opfermaske 2 dadurch vollständig geschlossen wird, während ein in Figur 1C dargestellter rechter Bereich mit einem weiten Abstand zwischen jeweiligen Teilbereichen der Opfermaske 2 weiterhin nicht vollständig aufgefüllt wird.

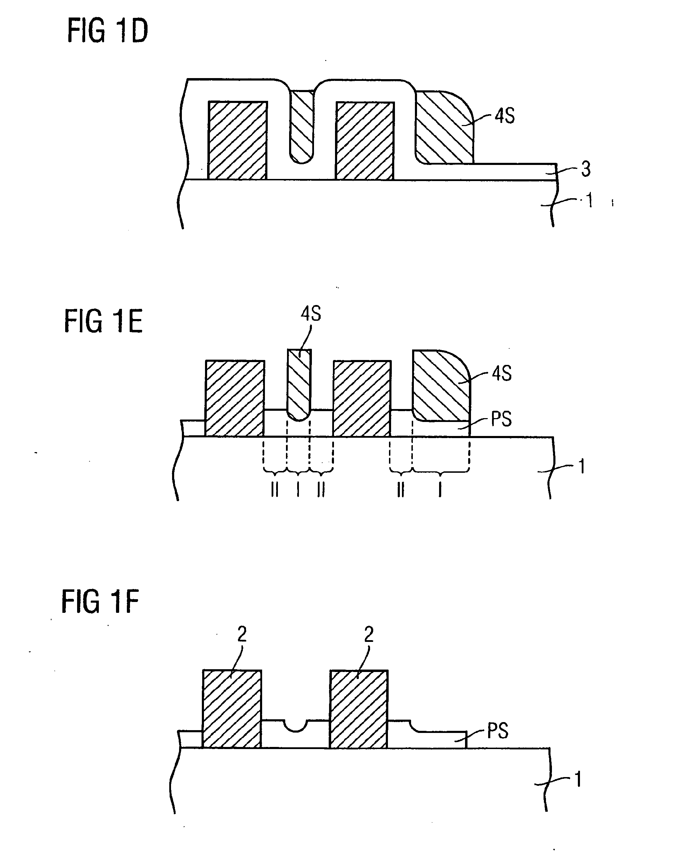

Gemäß Figur 1D wird nunmehr eine erste anisotrope Ätzung zum Erzeugen von Hilfs-Spacern 4S aus der zweiten Spacerschicht 4 an den Seitenwänden der ersten Spacerschicht 3 durchgeführt. Genauer gesagt wird hierbei unter Verwendung einer herkömmlichen Spacerätzung wie beispielsweise einem Trockenätzverfahren (RIE, Reactive Ion Etch) die zweite Spacerschicht 4 so lange abgetragen, bis nur mehr die in Figur 1D dargestellten Hilfs-Spacer 4S übrig bleiben. Zur Endpunkterkennung wird hierbei vorzugsweise die erste Spacerschicht 3 verwendet. Genauer gesagt wird demzufolge das anisotrope erste Ätzen dann beendet, wenn im Reaktionsgas Bestandteile der ersten Spacerschicht 3 erfasst werden können.

Gemäß Figur 1E wird anschließend eine zweite anisotrope Ätzung zum Erzeugen des eigentlichen planaren Spacers PS aus der ersten Spacerschicht 3 unter Verwendung der Hilfs-Spacer 4S durchgeführt, wobei wiederum ein Trockenätzverfahren wie beispielsweise reaktives Ionenätzen auf die erste Spacerschicht 3 angewendet wird. Der Endpunkt für dieses zweite a-nisotrope Ätzen wird hierbei vorzugsweise von einer vorbestimmten Zeitdauer festgelegt, bei der die vom Hilfs-Spacer 4S bedeckten Bereiche I des planaren Spacers PS im Wesentlichen eine gleiche Schichtdicke aufweisen wie die nicht bedeckten und somit geätzten Bereiche II des planaren Spacers PS.

Nach dem Entfernen der Hilfs-Spacer 4S erhält man die in Figur 1F dargestellte Schnittansicht, wobei an den Seitenwänden der Opfermaske 2 nur in ihrem unteren Bereich und somit ein im Wesentlichen planarer Spacer PS ausgebildet ist. Die Breite des planaren Spacers setzt sich im Wesentlichen aus der Summe der Schichtdicken der ersten und zweiten Spacerschichten 3 und 4 zusammen (sofern genügend Abstand zwischen den Opferstöpseln vorhanden ist), wobei seine Höhe im Wesentlichen einer Schichtdicke der ersten Spacerschicht 3 entspricht.

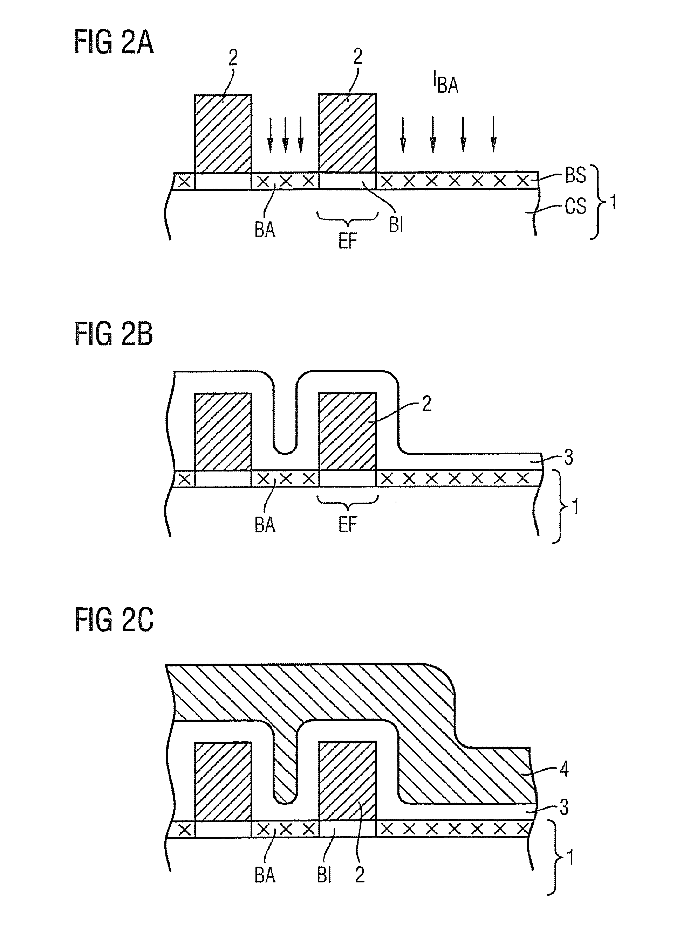

Derartige planare Spacer PS bieten eine Vielzahl von neuartigen Isolations-, Kontakt- und Implantationsmöglichkeiten, die Bauelemente mit verbesserten elektrischen Eigenschaften ermöglichen, wie nachfolgend anhand der Figuren 2A bis 2F ausführlich beschrieben wird.

Die Figuren 2A bis 2F zeigen vereinfachte Schnittansichten zur Veranschaulichung eines Verfahrens zur Herstellung eines Bipolartransistors mit planaren Spacern, wobei gleiche Bezugszeichen gleiche oder entsprechende Elemente bzw. Schichten wie in Figur 1 darstellen, weshalb auf eine wiederholte Beschreibung verzichtet wird.

Gemäß Figur 2A besteht das Trägersubstrat 1 aus einem als Kollektorschicht CS wirkenden beispielsweise n-dotiertem Halbleitersubstrat und einer darauf ausgebildeten beispielsweise mäßig bzw. schwach p-dotierten Basis-Halbleiterschicht, die als spätere Basisschicht BS wirkt. Vorzugsweise wird für das Halbleitersubstrat bzw. die Kollektorschicht CS ein n-dotiertes Si-Substrat und für die eine Basis des Bipolartransistors ausbildende Basisschicht BS eine epitaktisch aufgewachsene monokristalline p-dotierte Si-Schicht an der Oberfläche des Halbleitersubstrats CS aufgewachsen oder ein implantierter Bereich des Si-Substrats verwendet.

Nach dem Ausbilden der Opfermaske 2 an der Oberfläche der Basisschicht BS wird gemäß Figur 2A eine Basisanschluss-Implantation I_{BA} zum Ausbilden von niederohmigen Basisanschluss-Gebieten BA seitlich neben der Opfermaske bzw, den Stöpseln der Opfermaske 2 durchgeführt. Durch den Schutz der Opfermaske 2 wird gleichzeitig in einem Emitterfenster-Bereich EF eine demgegenüber höherohmige intrinsische Basis BI bei der Implantation maskiert (die intrinsische Basis wurde vorzugsweise bereits vor dem Spacerprozess gebildet). Auf Grund der fehlenden Implantation in diesem Bereich besitzt die intrinsische Basis im Wesentlichen die Dotierung der ursprünglich aufgewachsenen epitaktischen Basisschicht mit ihrer schwach p-dotierten Basis-Halbleiterschicht.

Gemäß Figur 2B bis 2E werden nunmehr die gleichen Schritte durchgeführt wie in Figuren 1B bis 1E, wodurch die planaren Spacer PS an den Seitenwänden der Opfermaske 2 in deren unterem Bereich ausgebildet werden. Sofern die Hilfs-Spacer 4S und die Opfermaske 2 ein gleiches Material aufweisen, wie z.B. Si₃N₄, können sie nachfolgend durch einen Nitridstrip in einem Arbeitsgang gleichzeitig entfernt werden.

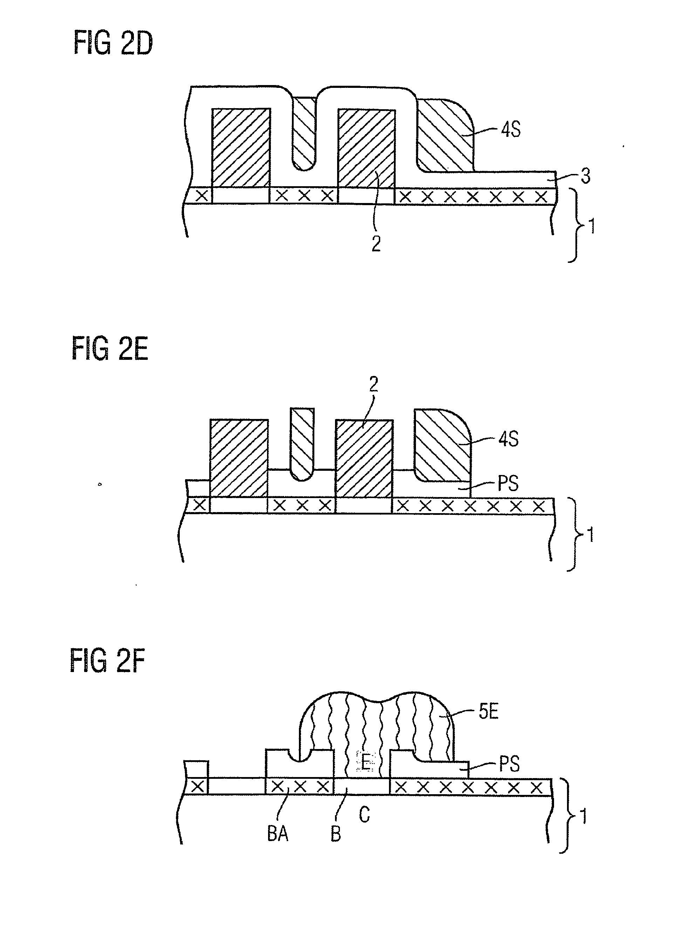

Gemäß Figur 2F wird nach dem Entfernen der Opfermaske 2 und der Hilfs-Spacer 4S eine Emitter-Halbleiterschicht 5 an der Oberfläche des Halbleiterwafers bzw. des Trägersubstrats 1 und somit an der Oberfläche der planaren Spacer PS und der intrinsischen Basis BI derart ausgebildet, dass sich die in Figur 2F dargestellte strukturierte Emitterschicht 5E ergibt. Vorzugsweise wird hierbei in situ dotiertes Poly-Silizium als Emitter-Halbleiterschicht 5 ganzflächig abgeschieden und anschließend fotolithographisch strukturiert, so dass die Emitterschicht 5E nur im Emitterfenster-Bereich EF die intrinsische Basis BI berührt bzw. kontaktiert und ansonsten von den im Wesentlichen planaren Spacern PS vom Trägersubstrat 1 isoliert ist.

Der in Figur 2F dargestellte zweite (bzw. rechte und hochdotierte) freiliegende Bereich des Trägersubstrats 1 dient hierbei als Kontaktbereich für die Basisanschlussgebiete BA, welche nunmehr exakt mit der intrinsischen Basis BI des Bipolartransistors selbstjustiert ausgerichtet sind.

Dadurch erreicht man besonders hohe Grenzfrequenzen, wobei insbesondere ein HF-Rauschen vermindert werden kann. Da darüber hinaus die Höhe der planaren Spacer sehr gering eingestellt werden kann, werden auch die Anschlusswiderstände für den Emitter E des Bipolartransistors äußerst gering. Folglich erhält man auf besonders einfache und kostengünstige Art und Weise einen Single-Poly-Bipolartransistor mit hervorragenden elektrischen Eigenschaften.

Ein derartiger Bipolartransistor ist darüber hinaus besonders geeignet in eine sogenannte BiCMOS-Schaltungsanordnung integriert zu werden.

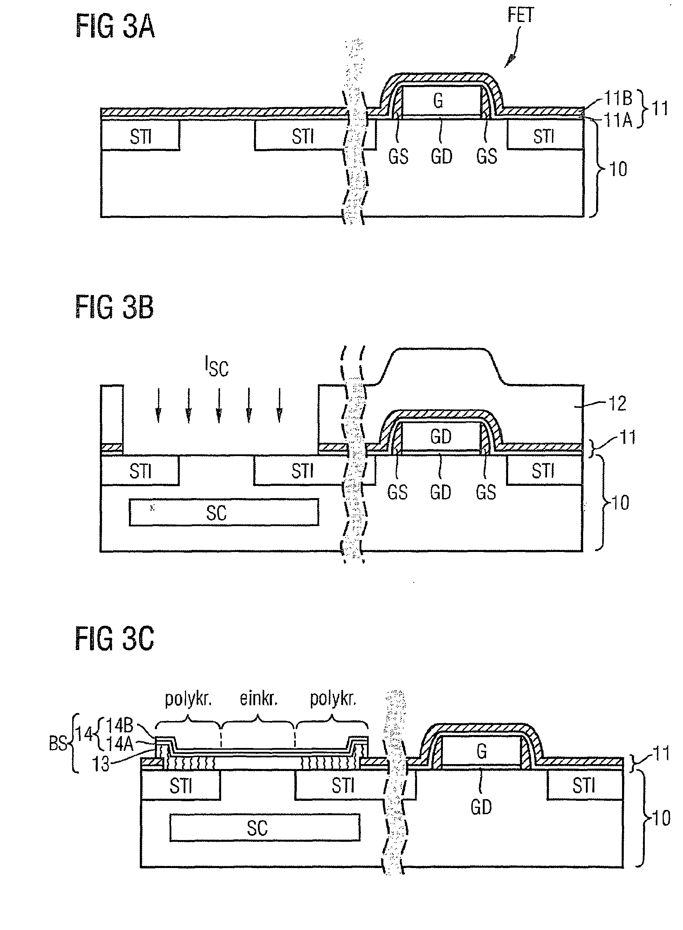

Figur 3A bis 3J zeigt vereinfachte Schnittansichten zur Veranschaulichung eines Verfahrens zur Herstellung einer BiCMOS-Schaltungsanordnung, wobei ein Bipolartransistor mit erfindungsgemäßen planaren Spacern in eine Schaltung mit Feldeffekttransistoren und insbesondere eine CMOS-Schaltung integriert wird. Gleiche Bezugszeichen bezeichnen hierbei gleiche oder entsprechende Elemente oder Schichten wie in Figuren 1 und 2, weshalb auf eine wiederholte Beschreibung nachfolgend verzichtet wird.

Figur 3A zeigt eine vereinfachte Schnittansicht einer BiCMOS-Schaltungsanordnung, wie sie beispielsweise zur Integration von Bipolartransistoren in CMOS-Schaltungen verwendet wird. Ein Halbleitersubstrat 10, welches vorzugsweise ein Si-Halbleitersubstrat darstellt, weist hierbei sogenannte flache Grabenisolierungen STI (Shallow Trench Isolation) als Isolationsgräben zur Festlegung von aktiven Gebieten innerhalb des Halbleitersubstrats 10 auf, der z.B. einen Halbleiterwafer darstellt. Innerhalb eines Feldeffekttransistor-Bereichs des monokristallinen Halbleitersubstrats 10 ist hierbei ein Feldeffekttransistor FET mit seiner Steuerelektrode bzw. seinem Gate G, seinem Gatedielektrikum GD sowie seinen optional vorhandenen Gatespacern GS zumindest teilweise fertiggestellt (normalerweise werden die Source-/Draingebiete erst später implantiert und annealed, damit sie nicht dem thermischen Budget des Bipolartransistorprozesses ausgesetzt sind; d.h. an dieser Stelle des Prozesses ist das Gate mit Spacern fertiggestellt, aber noch keine Source/Drain implantiert). Auf eine detaillierte Beschreibung derartiger CMOS-Feldeffekttransistoren wird an dieser Stelle verzichtet, da sie dem Fachmann allgemein bekannt sind.

Zur Realisierung einer Isolation bzw. einer Passivierung wird anschließend eine dünne Passivierungsschicht 11 vorzugsweise ganzflächig an der Oberfläche des Halbleitersubstrats 10, d.h. also auch an der Oberfläche im Bipolartransistor-Bereich, ausgebildet. Diese dielektrische Passivierungsschicht besteht beispielsweise aus einer SiO₂-Schicht 11A, welche unmittelbar auf dem Trägersubstrat 10 bzw. deren Isolationsgräben STI oder den Gatestapeln ausgebildet ist. Ferner kann eine Si₃N₄-Schicht 11B an der Oberfläche der Passivierungs-Teilschicht 11A abgeschieden werden, wobei die beiden Schichten im Wesentlichen dem Schutz des Feldeffekttransistor-Bereichs dienen.

Gemäß Figur 3B wird in einem nachfolgenden Schritt eine Maskenschicht 12 ganzflächig auf dem Wafer bzw. dem Trägersubstrat 10 aufgebracht und zum Freilegen des Bipolartransistor-Bereichs strukturiert. Beispielsweise wird ein Fotoresist ganzflächig aufgeschleudert und fotolithographisch strukturiert, wodurch man in einem Bipolartransistor-Bereich die Passivierungsschicht 11 unter Verwendung der Maske bzw. des Fotoresists 12 entfernen kann. Beispielsweise kann hierbei ein Nass- oder Trockenätzen des Nitrid/Oxid-Stapels der Passivierungsschicht 11 durchgeführt werden. Ferner kann an dieser Stelle auch eine eventuell noch vorhandene Gatedielektrikum-Schicht (nicht dargestellt) entfernt werden, welche üblicherweise ein sogenanntes Gateoxid darstellt.

Nach dem Entfernen der Passivierungsschicht 11 im Bipolartransistor-Bereich kann optional die in Figur 3B dargestellte Subkollektor-Implantation I_{SC} unter Verwendung des Fotoresists 12 zum Ausbilden eines vergrabenen Subkollektors SC im Halbleitersubstrat 10 durchgeführt werden. Beispielsweise wird hierbei eine Hochenergieimplantation für den Subkollektor SC bzw. eine diesem Gebiet entsprechende vergrabene Schicht (buried layer) durchgeführt.

Gemäß Figur 3C wird anschließend der Bipolartransistor gemäß den vorstehend beschriebenen Verfahrensschritten gemäß Figur 2 ausgebildet.

Vorzugsweise wird an dieser Stelle eine nicht-selektive Basisepitaxie zum epitaktischen Aufwachsen einer beispielsweise schwach p-dotierten Basis-Halbleiterschicht 13 auf dem Halbleitersubstrat 10 im Bipolarbereich durchgeführt, wobei an der Oberfläche des mit Oxid aufgefüllten Isolationsgrabens STI im Wesentlichen polykristallines Halbleitermaterial epitaktisch aufgewachsen wird, während an der Oberfläche des monokristallinen Halbleitersubstrats 10 einkristallines Halbleitermaterial als beispielsweise p-dotierten Basis-Halbleiterschicht 13 aufgewachsen wird. Beispielsweise kann bei diesem epitaktischen Aufwachsen ein Verbundhalbleiter und insbesondere SiGe oder SiGe:C als Basis-Halbleiterschicht 13 ausgebildet werden. An der Oberfläche dieser Basis-Halbleiterschicht 13 kann ferner eine dielektrische Abdeckschicht 14 ausgebildet werden, die beispielsweise aus einer Oxidschicht 14A besteht, die unmittelbar an der Oberfläche der beispielsweise p-dotierten Basis-Halbleiterschicht 13 ausgebildet ist, und einer Nitrid-Schicht 14B, die an der Oberfläche der Oxidschicht 14A ausgebildet ist, und gemeinsam die Basisschicht BS darstellen.

In einem weiteren nicht dargestellten Lithographieschritt wird nunmehr diese aus den Schichten 13 und 14 bestehende Basisschicht BS im Bipolartransistor-Bereich z.B. fotolithographisch strukturiert, bzw. in den übrigen Bereichen des Halbleiterwafers wie beispielsweise dem Feldeffekttransistor-Bereich entfernt, wodurch man die in Figur 3C dargestellte Schnittansicht erhält.

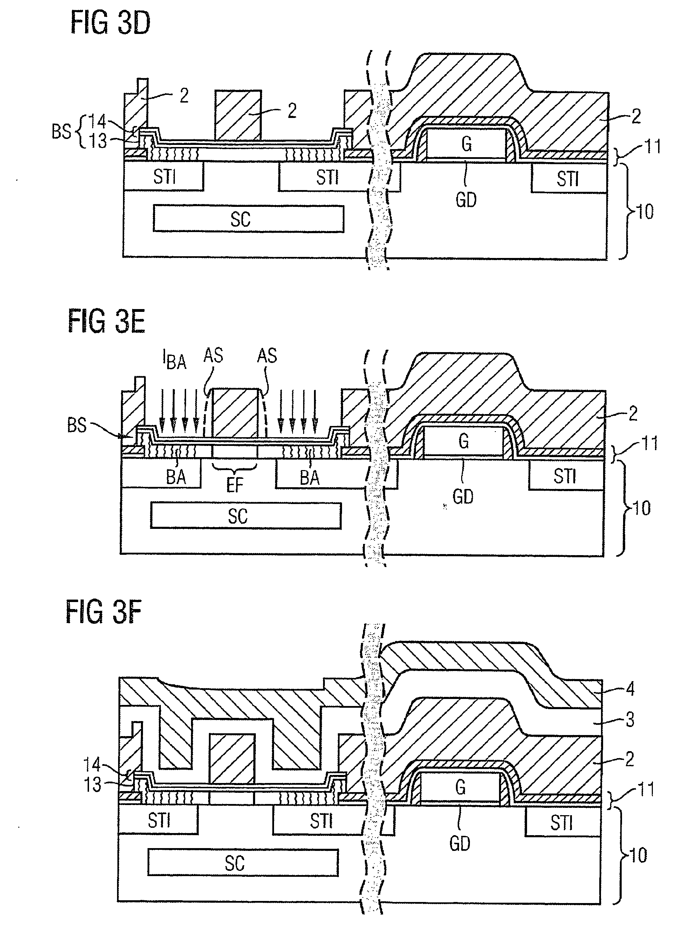

Gemäß Figur 3D erfolgt nunmehr das Ausbilden der Opfermaske 2, wobei der den Emitterfenster-Bereich festlegende Stöpsel der Opfermaske 2 vorzugsweise oberhalb des einkristallinen Bereichs der Basis-Halbleiterschicht 13 zu liegen kommt. Vorzugsweise wird hierbei wiederum eine relativ dicke Nitridschicht in Verbindung mit einer Basiskontaktlithographie zur Strukturierung der Nitrid-Opfermaske 2 verwendet.

Gemäß Figur 3E erfolgt nunmehr die Basisanschluss-Implantation I_{BA} zum Ausbilden von niederohmigen Basisanschlussgebieten BA hauptsächlich im polykristallinen Bereich der Basis-Halbleiterschicht 13.

Zum Festlegen eines vorbestimmten Abstands zwischen den niederohmigen Basisanschlussgebieten BA innerhalb der beispielsweise p-dotierten Basis-Halbleiterschicht 13 und der durch die Opfermaske 2 abgedeckten intrinsischen Basis BI im Emitterfensterbereich EF können optional an den Seitenwänden der Opfermaske bzw. dem Stöpsel 2 für das Emitterfenster EF Außenspacer AS in üblicher Art und Weise ausgebildet werden. Derartige Außenspacer beschränken somit den Implantationsbereich der Basisanschluss-Implantation I_{BA}. Damit kann man beispielsweise sicherstellen, dass die Basisanschluss-Implantation I_{BA} nur in die polykristallinen Bereiche der Basis-Halbleiterschicht 13 gelangt. Das effektive Emitterfenster EF im Bereich unterhalb des Opferstöpsels 2 befindet sich damit immer auf monokristallinem Gebiet, wodurch das laterale Wandern von Versetzungen in den Bereich der aktiven inneren Basis BI zuverlässig verhindert werden kann.

Gemäß Figur 3F wird anschließend die erste Spacerschicht 3, welche beispielsweise aus einer Oxidschicht, und die zweite Spacerschicht 4, welche beispielsweise aus einer Nitridschicht besteht, ganzflächig an der Oberfläche des Halbleiterwafers bzw. des Halbleitersubstrats 10 abgeschieden.

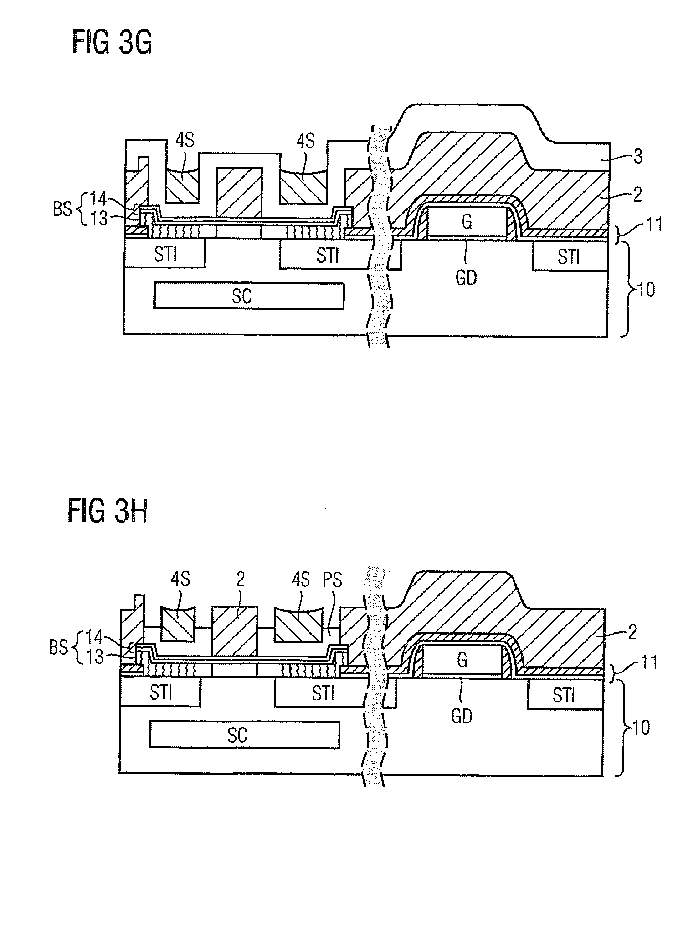

Beim Durchführen eines ersten anisotropen, d.h. gerichteten, Ätzverfahrens unter Verwendung einer Endpunkt-Erkennung auf der ersten Spacerschicht 3 wird die zweite Spacerschicht 4 derart zurückgeätzt, dass sich die Hilfs-Spacer 4S an den Seitenwänden der ersten Spacerschicht 3 gemäß Figur 3G ausbilden. Vorzugsweise wird hierbei wiederum ein Trockenätzverfahren und insbesondere ein RIE-Verfahren verwendet, wobei neben einer exakten Endpunkt-Erkennung auch ein Überätzen durchgeführt werden kann.

Gemäß Figur 3H wird, wie vorstehend beschrieben wurde, ein zweites anisotropes Ätzen und insbesondere ein Trockenätzen der Oxidschicht bzw. der ersten Spacerschicht 3 so lange durchgeführt, bis der annähernd planare Spacer PS ausgebildet ist. Genauer gesagt wird hierbei in Abhängigkeit von einer empirisch ermittelten Zeitdauer die erste Spacerschicht 3 so lange gerichtet zurückgeätzt, bis die vom Hilfs-Spacer 4S bedeckten Bereiche des planaren Spacers im Wesentlichen eine gleiche Schichtdicke aufweisen wie die frei liegenden Bereiches des planaren Spacers PS.

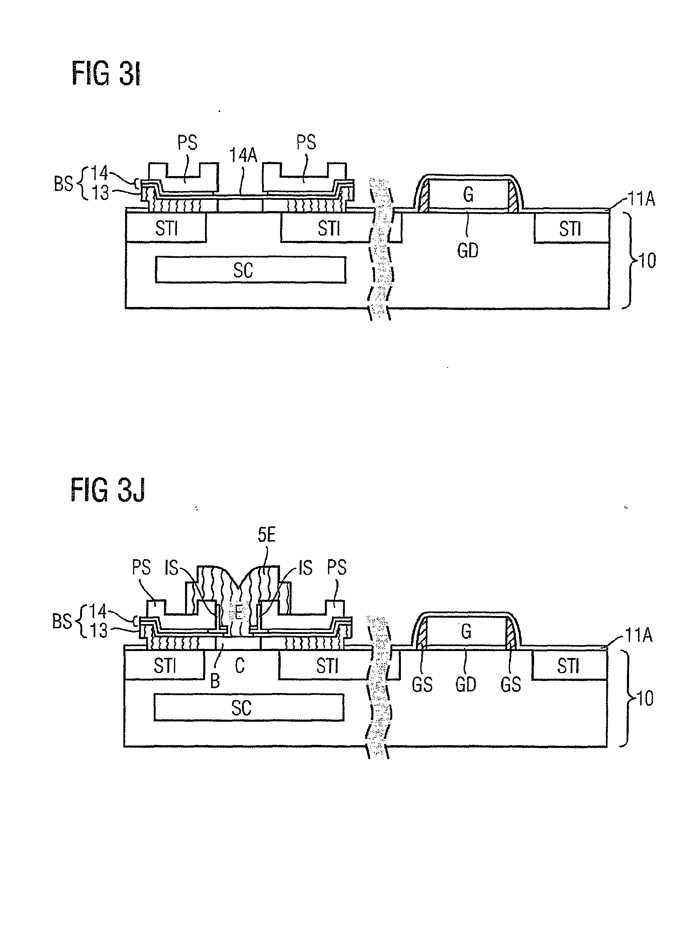

Gemäß Figur 3I werden anschließend die Hilfs-Spacer 4S, die Opfermaske 2 und die Nitridschicht 14B der dielektrischen Abdeckschicht 14 sowie die Nitridschicht 11B der Passivierungsschicht 11 entfernt. Da diese Schichten vorzugsweise alle das gleiche Material aufweisen, können sie vorteilhafterweise in einem Verfahrensschritt bzw. einem Nitridstrip gleichzeitig entfernt werden.

Gemäß Figur 3J kann nunmehr optional wiederum zum Festlegen eines vorbestimmten Abstands zwischen dem niederohmigen Basisanschlussgebieten BA und der intrinsischen Basis BI innerhalb des Emitterfenster-Bereichs EF ein Innenspacer IS an den Seitenwänden der planaren Spacer PS mittels herkömmlicher Spacertechnologie ausgebildet werden, wobei in gleicher Weise wie mit den Außenspacern AS wiederum ein laterales Wandern von Versetzungen in den Bereich der aktiven inneren Basis zuverlässig verhindert werden kann. Ferner kann dadurch ebenfalls der Abstand zwischen hochdotiertem und niedrigdotiertem Bereich der Basis-Halbleiterschicht 13 definiert eingestellt werden. Dieser Innenspacer IS kann beispielsweise L-förmig ausgebildet werden, wodurch der eigentlich wirkende Emitterfenster-Bereich definiert weiter verringert werden kann.

Zum Entfernen der Oxidschicht 14A im Emitterfenster-Bereich wird anschließend eine weitere Ätzung durchgeführt, wobei beispielsweise eine Nassätzung angewendet werden kann. Hierbei wird die dickere Oxidschicht 11A der Passivierungsschicht 11 gleichzeitig gedünnt, jedoch nicht vollständig entfernt. Abschließend erfolgt die Abscheidung des in situ dotierten Poly-Siliziums als Emitterschicht 5, wobei eine Strukturierung mittels herkömmlicher fotolithographischer Verfahren und einem Ätzstopp auf dem freiliegenden Oxid zum Ausbilden des dargestellten Emitterbereichs 5E erfolgt.

Auf diese Weise erhält man eine BiCMOS-Schaltungsanordnung, deren Bipolartransistor hervorragende elektrische Eigenschaften aufweist und darüber hinaus kostengünstig herzustellen ist.

Die Erfindung wurde vorstehend anhand einer BiCMOS-Schaltungsanordnung sowie eines npn-Bipolartransistors mit planaren Spacern beschrieben. Sie ist jedoch nicht darauf beschränkt und umfasst in gleicher Weise weitere Halbleiterbauelemente und insbesondere pnp-Transistoren, bei denen ein im Wesentlichen planarer Außenspacer verwendet wird. Der wesentliche Vorteil liegt hierbei darin, dass anders als bei herkömmlichen Spacern die Höhe des planaren Spacers frei einstellbar ist und im Wesentlichen nur von der Abscheidedicke der ersten Spacerschicht abhängt. Darüber hinaus vereinfacht die Planarität bzw. ebene Oberfläche des im Wesentlichen planaren Spacers die weitere Prozessführung.

## Patentansprüche

1. Verfahren zur Herstellung eines planaren Spacers (PS) mit den Schritten:
a) Ausbilden einer Opfermaske (2) auf einem Trägersubstrat (1);
b) Ausbilden einer ersten Spacerschicht (3) an der Oberfläche des Trägersubstrats (1) und der Opfermaske (2);
c) Ausbilden einer zweiten Spacerschicht (4) an der Oberfläche der ersten Spacerschicht (3);
d) Durchführen einer ersten anisotropen Ätzung zum Erzeugen von Hilfs-Spacern (4S) aus der zweiten Spacerschicht (4) an den Seitenwänden der ersten Spacerschicht (3);
e) Durchführen einer zweiten anisotropen Ätzung zum Erzeugen des planaren Spacers (PS) aus der ersten Spacerschicht (3) unter Verwendung der Hilfs-Spacer (4S); und
f) Entfernen der Hilfs-Spacer (4S),
**dadurch gekennzeichnet, dass** die zweite anisotrope Ätzung derart durchgeführt wird, dass die vom Hilfs-Spacer (4S) bedeckten Bereiche (I) des planaren Spacers (PS) im Wesentlichen eine gleiche Schichtdicke aufweisen wie die nicht bedeckten Bereiche (II) des planaren Spacers (PS).

2. Verfahren nach Patentanspruch 1,
**dadurch gekennzeichnet, dass** ein Ende der zweiten anisotropen Ätzung durch eine vorbestimmte Zeitdauer festgelegt wird.

3. Verfahren nach einem der Patentansprüche 1 oder 2,
**dadurch gekennzeichnet, dass** die Hilfs-Spacer (4S) und die Opfermaske (2) ein gleiches Material aufweisen und in Schritt f) gleichzeitig auch die Opfermaske (2) entfernt wird.

4. Verfahren nach einem der Patentansprüche 1 bis 3,
**dadurch gekennzeichnet, dass** die Opfermaske (2) Si₃N₄,
die erste Spacerschicht (3) SiO₂, und
die zweite Spacerschicht (4) Si₃N₄ aufweist.

5. Verfahren zur Herstellung eines Bipolartransistors mit den Schritten:
Ausbilden einer eine Basis-Halbleiterschicht (13) aufweisenden Basisschicht (BS) auf einem als Kollektorschicht (CS) wirkenden Halbleitersubstrat zur Realisierung eines Trägersubstrats (1); und
Herstellen der planaren Spacer (PS) nach einem der Patentansprüche 1 bis 4, wobei
nach dem Ausbilden der Opfermaske (2) eine Basisanschluss-Implantation (I_{BA}) zum Ausbilden von niederohmigen Basisanschlussgebieten (BA) und einer demgegenüber höherohmigen intrinsischen Basis (BI) in der Basisschicht (BS) durchgeführt wird, und
nach einem Entfernen der Opfermaske (2) eine als Emitterschicht (5E) dienende Emitter-Halbleiterschicht an der Oberfläche des Trägersubstrats (1) und der planaren Spacer (PS) ausgebildet und strukturiert wird.

6. Verfahren nach Patentanspruch 5,
**dadurch gekennzeichnet, dass** zumindest ein Teil der Opfermaske (2) einen Emitterfenster-Bereich (EF) zum Festlegen eines Kontaktbereichs der Emitterschicht (5E) mit der intrinsischen Basis (BI) definiert.

7. Verfahren nach Patentanspruch 6,
**dadurch gekennzeichnet, dass** zum Festlegen eines vorbestimmten Abstands zwischen den niederohmigen Basisanschlussgebieten (BA) und der intrinsischen Basis (BI) im Emitterfenster-Bereich (EF) Außenspacer (AS) an den Seitenwänden der Opfermaske (2) und/oder Innenspacer (IS) an den Seitenwänden der planaren Spacer (PS) ausgebildet werden.

8. Verfahren nach einem der Patentansprüche 6 oder 7,
**dadurch gekennzeichnet, dass** die Basis-Halbleiterschicht (13) zumindest im Emitterfenster-Bereich (EF) als monokristalline Halbleiterschicht epitaktisch aufgewachsen wird.

9. Verfahren nach einem der Patentansprüche 6 oder 7,
**dadurch gekennzeichnet, dass** die Basis-Halbleiterschicht (13) zumindest im Emitterfenster-Bereich (EF) als monokristalline Halbleiterschicht mittels Implantation im Siliziumsubstrat ausgebildet wird.

10. Verfahren nach einem der Patentansprüche 5 bis 9,
**dadurch gekennzeichnet, dass** die Basis-Halbleiterschicht (13) einen Verbundhalbleiter und insbesondere SiGe oder SiGe:C aufweist.

11. Verfahren nach einem der Patentansprüche 5 bis 10,
**dadurch gekennzeichnet, dass** beim Ausbilden der Basisschicht (BS) eine dielektrische Abdeckschicht (14) an der Oberfläche der Basis-Halbleiterschicht (13) ausgebildet wird.

12. Verfahren nach Patentanspruch 11,
**dadurch gekennzeichnet, dass** die Abdeckschicht (14) eine an der Oberfläche der Basis-Halbleiterschicht (13) ausgebildete SiO₂-Schicht (14A) und eine darauf ausgebildete Si₃N₄-Schicht (14B) aufweist.

13. Verfahren nach einem der Patentansprüche 5 bis 12,
**dadurch gekennzeichnet, dass** die als Emitterschicht (5E) dienende Emitter-Halbleiterschicht eine in situ dotierte oder implantierte polykristalline Halbleiterschicht und insbesondere Poly-Si-Schicht darstellt.

14. Verfahren zur Herstellung einer BiCMOS-Schaltungsanordnung mit den Schritten:
Vorbereiten eines Halbleitersubstrats (10);
Ausbilden von zumindest einem teilweise fertiggestellten Feldeffekttransistor (FET) in einem Feldeffekttransistor-Bereich des Halbleitersubstrats (10);
Ausbilden einer Passivierungsschicht (11) an der Oberfläche des Halbleitersubstrats (10) und über den Feldeffekttransistor-Strukturen;
Entfernen der Passivierungsschicht (11) zum Freilegen des Halbleitersubstrats (10) in zumindest einem Bipolartransistor-Bereich; und
Ausbilden eines Bipolartransistors mit planaren Spacern nach einem der Patentansprüche 5 bis 13 an den freigelegten Bereichen des Halbleitersubstrats (10).

15. Verfahren nach Patentanspruch 14,
**dadurch gekennzeichnet, dass** beim Vorbereiten des Halbleitersubstrats (10) Isolationsgräben (STI) zum Festlegen von aktiven Bereichen in einem monokristallinen Halbleitersubstrat (10) ausgebildet werden, wobei beim Ausbilden der Basis-Halbleiterschicht (13) an der Oberfläche der Isolationsgräben (STI) Bereiche aus polykristallinem Halbleitermaterial und ansonsten Bereich aus monokristallinem Halbleitermaterial ausgebildet werden.

16. Verfahren nach einem der Patentansprüche 14 oder 15,
**dadurch gekennzeichnet, dass** die Hilfs-Spacer (4S), die Opfermaske (2) und zumindest ein oberer Teil der Abdeckschicht (14B) ein gleiches Material aufweisen und gleichzeitig entfernt werden.

17. Verfahren nach einem der Patentansprüche 14 bis 16,
**dadurch gekennzeichnet, dass** nach dem Entfernen der Passivierungsschicht (11) eine Subkollektor-Implantation (I_{SC}) zum Ausbilden eines vergrabenen Subkollek-tors (SC) im Halbleitersubstrat (10) im Bipolartransistor-Bereich durchgeführt wird.

## Claims

1. A method for producing a planar spacer (PS) having the following steps:
a) formation of a sacrificial mask (2) on a mount substrate (1);
b) formation of a first spacer layer (3) on the surface of the mount substrate (1) and on the sacrificial mask (2);
c) formation of a second spacer layer (4) on the surface of the first spacer layer (3);
d) carrying out a first anisotropic etching step for production of auxiliary spacers (4S) from the second spacer layer (4) on the side walls of the first spacer layer (3);
e) carrying out a second anisotropic etching step in order to produce the planar spacer (PS) from the first spacer layer (3) using the auxiliary spacer (4S); and
f) removal of the auxiliary spacer (4S),
**characterized in that**
the second anisotropic etching step is carried out in such a manner that those areas (I) of the planar spacer (PS) which are covered by the auxiliary spacer (4S) have essentially the same layer thickness as the uncovered areas (II) of the planar spacer (PS).

2. The method as claimed in patent claim 1, **characterized in that** one end of the second anisotropic etching step is defined by a predetermined time period.

3. The method as claimed in patent claim 1 or 2, **characterized in that** the auxiliary spacer (4S) and the sacrificial mask (2) are composed of the same material, and the sacrificial mask (2) is also removed at the same time in step (f).

4. The method as claimed in one of patent claims 1 to 3,
**characterized in that** the sacrificial mask (2) comprises Si₃N₄, the first spacer layer (3) comprises SiO₂ and the second spacer layer (4) comprises Si₃N₄.

5. A method for production of a bipolar transistor having the following steps:
formation of a base layer (BS) comprising a base semiconductor layer (13), on a semiconductor substrate which acts as a collector layer (CS), in order to produce a mount substrate (1); and
production of planar spacers (PS) as claimed in one of patent claims 1 to 4, in which
after the formation of the sacrificial mask (2), a base connection implantation (I_{BA}) is carried out in order to form low-impedance base connection regions (BA) and an intrinsic base (BI), which has a higher impedance than this, in the base layer (BS), and
after removal of the sacrificial mask (2), an emitter semiconductor layer which is used as an emitter layer (5E) is formed and structured on the surface of the mount substrate (1) and of the planar spacer (PS).

6. The method as claimed in patent claim 5, **characterized in that** at least a part of the sacrificial mask (2) defines an emitter window area (EF) for definition of a contact area of the emitter layer (5E) with the intrinsic base (BI).

7. The method as claimed in patent claim 6, **characterized in that** outer spacers (AS) are formed on the side walls of the sacrificial mask (2) and/or inner spacers (IS) are formed on the side walls of the planar spacers (PS) in order to define a predetermined distance between the low-impedance base connection regions (BA) and the intrinsic base (BI) in the emitter window area (EF).

8. The method as claimed in one of patent claims 6 or 7,
**characterized in that** the base semiconductor layer (13) is epitaxially grown as a monocrystalline semiconductor layer at least in the emitter window area (EF).

9. The method as claimed in one of patent claims 6 or 7,
**characterized in that** the base semiconductor layer (13) is formed, at least in the emitter window area (EF) as a monocrystalline semiconductor layer by means of implantation in the silicon substrate.

10. The method as claimed in one of patent claims 5 to 9,
**characterized in that** the base semiconductor layer (13) comprises a compound semiconductor and, in particular, SiGe or SiGe:C.

11. The method as claimed in one of patent claims 5 to 10,
**characterized in that** a dielectric covering layer (14) is formed on the surface of the base semiconductor layer (13), during the formation of the base layer (BS).

12. The method as claimed in patent claim 11,
**characterized in that** the covering layer (14) comprises an SiO₂ layer (14A), which is formed on the surface of the base semiconductor layer (13), and an Si₃N₄ layer (14B), which is formed on it.

13. The method as claimed in one of patent claims 5 to 12,
**characterized in that** the emitter semiconductor layer which is used as the emitter layer (5E) represents an in-situ-doped or implanted polycrystalline semiconductor layer and, in particular, poly-silicon layer.

14. A method for production of a BiCMOS circuit arrangement having the following steps:
preparation of a semiconductor substrate (10);
formation of an at least partially complete field-effect transistor (FET) in a field-effect transistor area of the semiconductor substrate (10);
formation of a passivation layer (11) on the surface of the semiconductor substrate (10) and over the field-effect transistor structures;
removal of the passivation layer (11) in order to expose the semiconductor substrate (10) in at least one bipolar transistor area; and
formation of a bipolar transistor with planar spacers as claimed in one of patent claims 5 to 13 on the exposed areas of the semiconductor substrate (10).

15. The method as claimed in patent claim 14, **characterized in that**, during the preparation of the semiconductor substrate (10), isolation trenches (STI) are formed in order to define active areas in a monocrystalline semiconductor substrate (10), with areas composed of polycrystalline semiconductor material and, apart from this, an area composed of monocrystalline semiconductor material, being formed on the surface of the isolation trenches (STI) during the formation of the base semiconductor layer (13).

16. The method as claimed in one of patent claims 14 or 15,
**characterized in that** the auxiliary spacers (4S), the sacrificial mask (2) and at least an upper part of the covering layer (14B) are composed of an identical material, and are removed at the same time.

17. The method as claimed in one of patent claims 14 to 16,
**characterized in that**, after the removal of the passivation layer (11), a subcollector implantation step (I_{SC}) is carried out in the bipolar transistor area in order to form a buried subcollector (SC) in the semiconductor substrate (10).

## Revendications

1. Procédé de production d'un espaceur (PS) plan, comprenant les stades dans lesquels :
a) on forme un masque (2) sacrificiel sur un substrat (1) formant support ;
b) on forme une première couche (3) d'espaceur à la surface du substrat (1) formant support et du masque (2) sacrificiel ;
c) on forme une deuxième couche (4) d'espaceur à la surface de la première couche (3) d'espaceur ;
d) on effectue une première attaque anisotrope, pour produire des espaceurs (4S) auxiliaires, en la deuxième couche (4) d'espaceur sur les parois latérales de la première couche (3) d'espaceur ;
e) on effectue une deuxième attaque anisotrope, pour produire l'espaceur (PS) plan, en la première couche (3) d'espaceur en utilisant les espaceurs (4S) auxiliaires ; et
f) on élimine les espaceurs (4S) auxiliaires,
**caractérisé en ce qu'**on effectue la deuxième attaque anisotrope, de manière à ce que les zones (1) de l'espaceur (PS) plan recouvertes des espaceurs (4S) auxiliaires aient sensiblement une même épaisseur de couche que les zones (II) de l'espaceur (PS) plan qui ne sont pas recouvertes.

2. Procédé suivant la revendication 1,
**caractérisé en ce qu'**on fixe une fin de la deuxième attaque anisotrope par une durée déterminée à l'avance.

3. Procédé suivant l'une des revendications 1 ou 2,
**caractérisé en ce que** les espaceurs (4S) auxiliaires et le masque (2) sacrificiel ont un même matériau et, au stade f), le masque (2) sacrificiel est éliminé aussi en même temps.

4. Procédé suivant l'une des revendications 1 à 3, **caractérisé en ce que**
le masque (2) sacrificiel comprend du Si₃N₄,
la première couche (3) d'espaceur comprend du SiO₂, et
la deuxième couche (4) d'espaceur comprend du Si₃N₄.

5. Procédé de production d'un transistor bipolaire, comprenant les stades dans lesquels :
on forme une couche (BS) de base ayant une couche (13) semiconductrice de base sur un substrat semiconducteur servant de couche (CS) de collecteur, pour la réalisation d'un substrat (1) formant support ; et
on produit l'espaceur (PS) plan suivant l'une des revendications 1 à 4, dans lequel
après la formation du masque (2) sacrificiel, on effectue dans la couche (BS) de base une implantation (I_{BA}) de borne de base,
pour la formation de domaines (BA) de borne de base de petite valeur ohmique et d'une base (BI) intrinsèque en regard de grande valeur ohmique, et
après une élimination du masque (2) sacrificiel, on forme et
on structure une couche semiconductrice d'émetteur servant de couche (5E) d'émetteur à la surface du substrat (1) formant support et de l'espaceur (PS) plan.

6. Procédé suivant la revendication 5,
**caractérisé en ce qu'**au moins une partie du masque (2) sacrificiel définit une zone (EF) de fenêtre d'émetteur, pour la fixation d'une zone de contact de la couche (5E) d'émetteur avec la base (BI) intrinsèque.

7. Procédé suivant la revendication 6,
**caractérisé en ce que**, pour la fixation d'une distance déterminée à l'avance entre les domaines (BA) de borne de base de petite valeur ohmique et la base (BI) intrinsèque, on forme dans la zone (EF) de fenêtre d'émetteur des espaceurs (AS) extérieurs sur les parois latérales du masque (2) sacrificiel et/ou des espaceurs (IS) intérieurs sur les parois latérales de l'espaceur (PS) plan.

8. Procédé suivant l'une des revendications 6 ou 7,
**caractérisé en ce qu'**on fait croître, par épitaxie, sous la forme d'une couche semiconductrice monocristalline, la couche (13) semiconductrice de base, au moins dans la zone (EF) de fenêtre d'émetteur.

9. Procédé suivant l'une des revendications 6 ou 7,
**caractérisé en ce qu'**on forme la couche (13) semiconductrice de base, au moins dans la zone (EF) de fenêtre d'émetteur, sous la forme d'une couche semiconductrice monocristalline au moyen d'une implantation dans le substrat en silicium.

10. Procédé suivant l'une des revendications 5 à 9,
**caractérisé en ce que** la couche (13) semiconductrice de base comprend un semiconducteur composite et, notamment, du SiGe ou du SiGe:C.

11. Procédé suivant l'une des revendications 5 à 10,
**caractérisé en ce que**, lors de la formation de la couche (BS) de base, on forme une couche (14) diélectrique de recouvrement à la surface de la couche (13) semiconductrice de base.

12. Procédé suivant la revendication 11,
**caractérisé en ce que** la couche (14) de recouvrement a une couche (14A) en SiO₂ formée à la surface de la couche (13) semiconductrice de base et une couche (14B) en Si₃N₄, qui est formée dessus.

13. Procédé suivant l'une des revendications 5 à 12,
**caractérisé en ce que** la couche semiconductrice d'émetteur servant de couche (5E) d'émetteur représente une couche semiconductrice polycristalline dopée in situ ou implantée et, notamment, une couche en poly-Si.

14. Procédé de production d'un montage BiCMOS, comprenant les stades dans lesquels
on prépare un substrat (10) semiconducteur ;
on forme au moins un transistor (FET) à effet de champ, en partie fini de fabrication, dans une zone de transistor à effet de champ du substrat (10) semiconducteur ;
on forme une couche (11) de passivation à la surface du substrat (10) semiconducteur et sur les structures de transistor à effet de champ ;
on élimine la couche (11) de passivation, pour mettre à nu le substrat (10) semiconducteur dans au moins une zone de transistor bipolaire ; et
on forme un transistor bipolaire ayant des espaceurs plan suivant l'une des revendications 5 à 13 sur les zones mises à nu du substrat (10) semiconducteur.

15. Procédé suivant la revendication 14,
**caractérisé en ce que**, lors de la préparation du substrat (10) semiconducteur, on forme des sillons (STI) isolants, pour fixer des zones actives dans un substrat (10) semiconducteur monocristallin, dans lequel, lors de la formation de la couche (13) semiconductrice de base, on forme à la surface des sillons (STI) d'isolation des zones en matériau semiconducteur polycristallin et, sinon, une zone en un matériau semiconducteur monocristallin.

16. Procédé suivant l'une des revendications 14 ou 15,
**caractérisé en ce que** les espaceurs (4S) auxiliaires, le masque (2) sacrificiel et au moins une partie supérieure de la couche (14B) de recouvrement ont un même matériau et sont éliminés en même temps.

17. Procédé suivant l'une des revendications 14 à 16,
**caractérisé en ce que**, après l'élimination de la couche (11) de passivation, on effectue une implantation (I_{SC}) de sous-collecteur, pour la formation d'un sous-collecteur (SC) enterré dans le substrat (10) semiconducteur dans la zone du transistor bipolaire.
